# EUROPEAN PATENT APPLICATION

(11) **EP 0 935 135 A1**
(43) Date of publication of application: **11.08.1999**
(21) Application number: 98650049.4
(22) Date of filing: 04.08.1998
(51) Int. Cl.: G01N 21/88, G01B 11/24

(54) **System for measuring solder bumps**

(30) Priority: 09.02.1998 IE 980092; 25.03.1998 IE 980222
(71) Applicant: M.V. Research Limited, Dublin 2 (IE)
(72) Inventor: Mahon, James, Dublin 9 (IE); O'Neill, Sean, Collins Avenue, Dublin 9 (IE); Conlon, Peter, Ballsbridge, Dublin 4 (IE); Kootsookos, Peter c/o M.V. Research Limited, Dublin 2 (IE)
(74) Representative: Weldon, Michael James

(57) **Abstract**

Solder bumps on a substrate are measured by initially using a camera (41) to determine two-dimensional location of the bumps. Images from the camera (41) are processed firstly when the substrate is illuminated by upper LEDs (421) providing on-axis illumination. This allows simple filtering out of the bare parts of pads. While the gantry head is at simple illumination of the substrate. After two-dimensional inspection, the gantry head is moved for volume measurement of selected solder bumps using a laser device (44) and a laser sensor (46). The laser device (44) emits a beam (60) in the form of a sheet of light which impinges on the substrate as a line. Because the beam (60) is at an angle to the vertical, the bumps cause an irregularity in the line as used by the camera (46). The extent of the irregularity indicates the bump height.

## Description

The invention relates to measurement of solder paste on substrates.

With increasing miniaturisation of electronic circuits, the location and size of solder paste bumps is becoming increasingly important in manufacturing processes. Detection of faults at a late stage of production is often very costly because re-work is difficult and time-consuming.

Systems have been developed to inspect solder paste bumps for improved quality control. One such system is described in United States patent specification number US 5105149 (Matsushita). This system includes a top camera and four side cameras. For illumination of the target, there is a ring-shaped upper light source and a set of four side light sources. These cameras and light sources are used primarily for two-dimensional inspection of a target in the plane of the substrate (often referred to as the X-Y plane). In addition, the system includes a laser device and two associated sensors for detecting reflected laser light. The laser device and sensors are used primarily for detection of the height (in the Z dimension) of solder. It appears that a very large degree of control would be required in order to control all of the cameras and light sources. For example, the laser beam is emitted as a focused spot which is scanned across the target by rotation of a miniature mirror. Also, because there is a total of seven light sensors, synchronisation of signals and image processing would be particularly difficult and would require lengthy time periods. Such inspection time periods would not be acceptable in most electronic circuit manufacturing environments.

Other systems for solder inspection have also been devised. In US 5206705 (Matsushita) a system is described in which the laser beam is swept across a chip or other component to provide a datum for reference when inspecting solder. Little detail is given as to how the image processing is achieved, however, it appears that again it would be complex because of the necessity to sweep the laser beam and perform additional processing for the references.

Another system is described in US 5495337 (Machine Vision Products). In this system, "sunset" and "sunrise" sets of beams are directed at the target. Light from all of the beams is processed to determine a centre of intensity. Again, it appears that an extensive level of image processing would be required.

It is therefore an object of the invention to provide a solder paste measurement system which accurately determines the positions and volumes of individual solder blobs in a simple, fast and efficient manner suitable for high-speed manufacturing environments.

According to the invention, there is provided a solder bump measurement system comprising means of supporting a target substrate with solder bumps, a light source mounted to direct a beam of light at the target, a camera mounted to receive reflected light, and an image processor connected to the camera and comprising means for digitising received light signals and analysing the resultant digital signals to determine height of the solder bump, characterised in that,
the light source emits a sheet of light which impinges on the target as a line, and
the camera and the light source are mounted at an angle with respect to each other whereby differences in height at which the beam impinges on the target are represented as a pattern in the line as viewed by the camera.

Preferably, the camera and the light source are mounted so that the camera is vertically above the location at which the light beam impinges on the target. Ideally, the camera and the light source are co-planar and are at a mutual angle in the range of 15° to 25°, and preferably the angle is approximately 20°.

In one embodiment, the sheet of light impinges on the substrate at an angle of approximately 45° to both orthogonal directions of orientation of the solder blobs.

In another embodiment, the image processor comprises means for representing each line of light as a row of pixels, the intensity of each pixel being proportional to the extent of deviation of the corresponding light.

Preferably, the system comprises a gantry, and the camera and the light source are mounted on a gantry head, and the gantry further comprises a drive means for moving the head to selected target regions and to step drive the head to a series of successive discreet positions within the target region.

In one embodiment, the image processor comprises means for filtering received digital light signals using median filtering techniques to eliminate pixel outliers.

Preferably, the system initially performs a two-dimensional inspection of the target to determine the location of solder bumps to be measured.

In another embodiment, the system comprises a vertically-mounted camera, a light source for emitting on-axis beams and a light source for emitting off-axis beams, and the image processor comprises:-
means for switching the light sources, and
means in the image processor for processing light signals reflected from the on-axis beams to eliminate bare pads, and for processing reflected light from off-axis beams to eliminate a substrate.

Ideally, the light sources are light emitting diodes and are arranged in rings symmetrically around the camera axis.

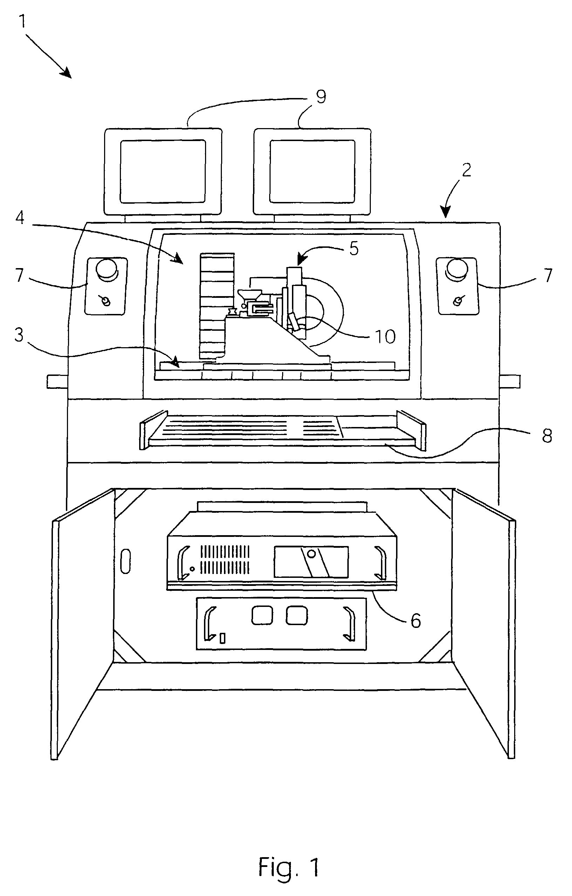

The invention will be more clearly understood from the following description of some embodiments thereof, given by way of example only with reference to the accompanying drawings in which:-
Fig. 1 is a front view of a measurement system of the invention;
Fig. 2 is a more detailed side perspective view of the system;
Fig. 3 is a perspective view showing a gantry head of the system in more detail;
Figs. 4 and 5 are diagrammatic front views showing two-dimensional inspection of the systems;
Fig. 6 is a diagrammatic front view showing three-dimensional inspection;
Fig. 7 is a plan view of three-dimensional inspection;
Fig. 8 is a diagrammatic representation of a pixel height map for image processing;
Figs. 9 and 10 are flow charts illustrating image processing of the system; and
Figs. 11 and 12 are graphical representations of images captured by the system.

Referring to the drawings a solder paste measurement system 1 of the invention comprises a housing 2 through which extends a conveyor system 3. A gantry 4 is mounted over the conveyor system and it includes a gantry head 5 which moves under robotic control. An image processor 6 is connected to the gantry head 5 and it is controlled by a pair of control panels 7 and a keyboard 8. Output signals are displayed on monitors 9.

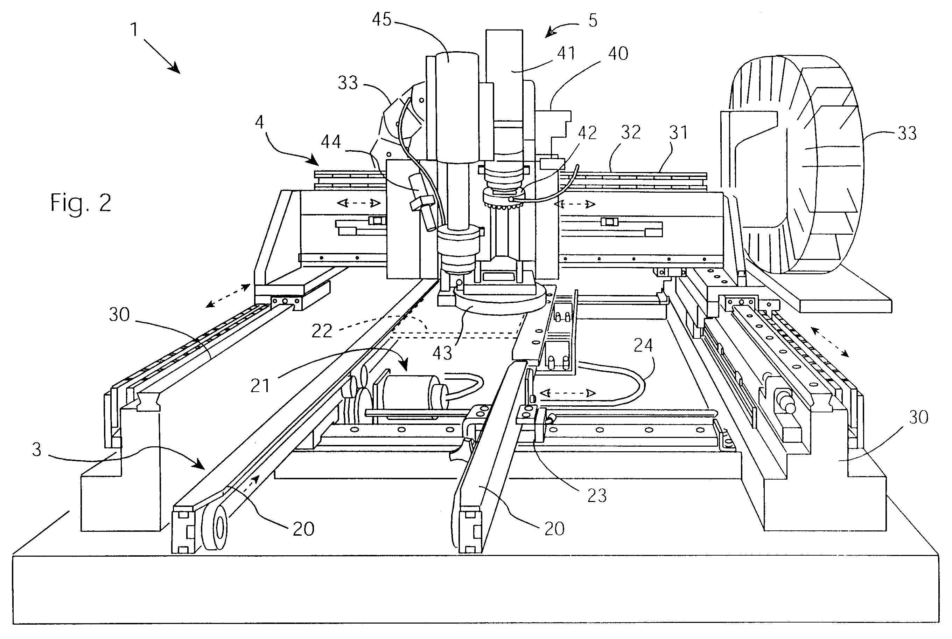

Referring in particular to Fig. 2, the conveyor system 3 comprises a pair of rails 20 within which belts are driven by drive motors 21 to move targets 22 into a measurement position. The right hand conveyor as viewed in Fig. 2 is mounted on carriages 23 for lateral adjustment by a pneumatic system 24.

The gantry 4 comprises a pair of rails 30 on which runs a gantry beam 31. The gantry beam 31 has linear motors 32 , and power is supplied by cable looms 33.

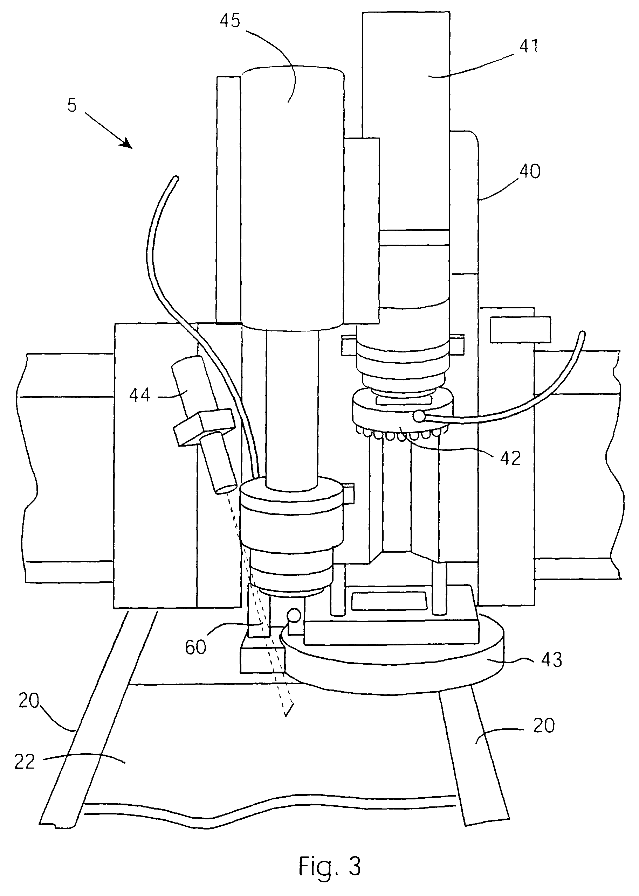

Referring in particular to Figs. 2 and 3, the gantry head 5 comprises a support plate 40 which supports a camera 41 mounted in vertical alignment. The plate 40 also supports an upper ring 42 of LEDs arranged symmetrically about the camera axis. In addition, a lower LED ring 43 is also mounted symmetrically about the camera axis. The lower ring 43 is at a height of approximately 20mm above the substrate and the LEDs are arranged in a circular configuration with a diameter of approximately 112mm. The upper ring 42 is at a height of approximately 126mm and it has a diameter of 40mm.

In addition, the head 5 supports a laser device 44 mounted at an angle of approximately 20° to vertical. A laser sensor 45 is also mounted on the head 5 with a vertical axis. The sensor 45 is a combined optical sensor, A/D converter, and processor arranged with a parallel architecture chip. The parallel architecture allows processing of the 256 x 256 pixel image at greater than 500 frames per second. The sensor 45 has a small field of view to allow high resolution. The camera 41 on the other hand has a different lens arrangement for a wider field of view, and has an image size of greater than 1000 x 1000 pixels.

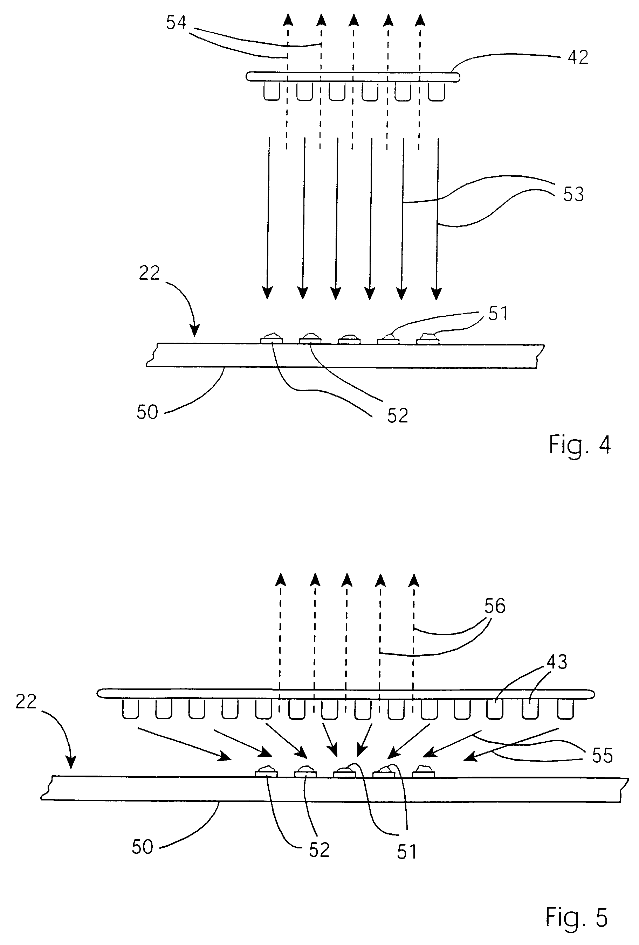

In operation, the system 1 receives successive circuit boards onto which solder paste blobs have been applied, such a by screen printing. The circuit may or may not also include components. Referring briefly to Figs. 4 to 6, this measurement involves initially determining in the horizontal plane (plane of the substrate) the location of the solder blobs. In these diagrams the substrate is indicated by the numeral 50, and solder blobs 51 are on pads 52. As shown in Fig. 4, the system performs an initial inspection using on-axis beams 53 emitted by the upper LEDs 42, on-axis reflected light 54 being captured by the camera 41. While the gantry head is at the same position, off-axis beams 55 are subsequently emitted by the lower LEDs 43 and the resulting reflected light 56 is also detected by the camera. The first inspection using the upper LED 42 is used to eliminate from the active image the bare parts of the pads 52, while the second inspection using the lower LEDs 43 eliminates the substrate 50.

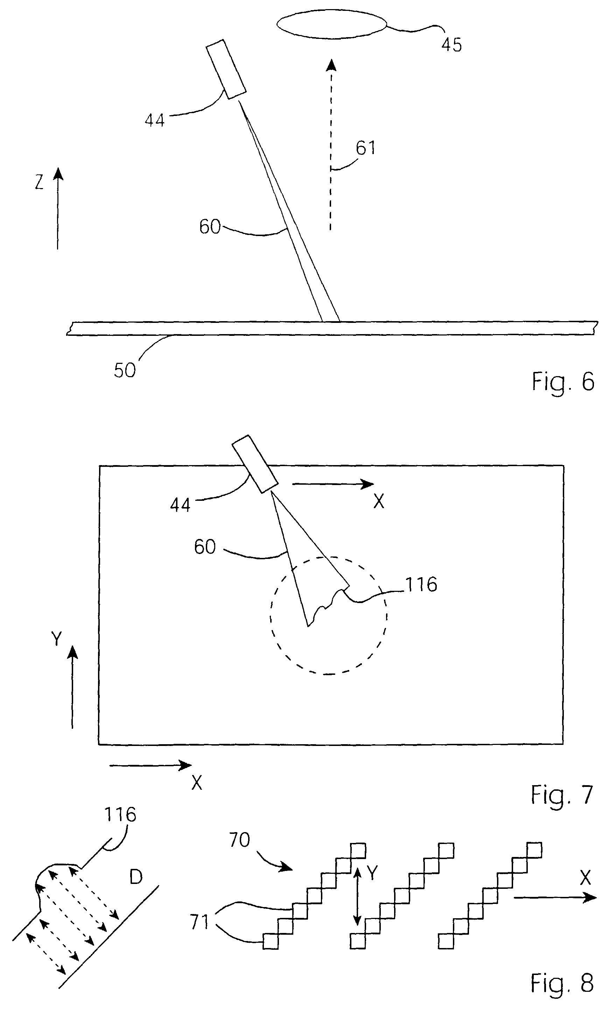

After the two-dimensional inspection, the locations of the solder blobs has been determined and the gantry head 5 is then moved to selected positions of the substrate 50 to determine height of particular solder blobs. The laser device 44 emits a sheet of light 60 which impinges as a straight line on flat targets. The line is at an angle of 45° to the X axis. Reflected light 61 is picked up by the laser sensor 45. As shown in Fig. 7, when the beam 60 impinges on objects such as solder blobs, the line is distorted. This pattern is analysed by the image processor 6, which represents successive lines in a height map 70 having diagonal rows of pixels 71.

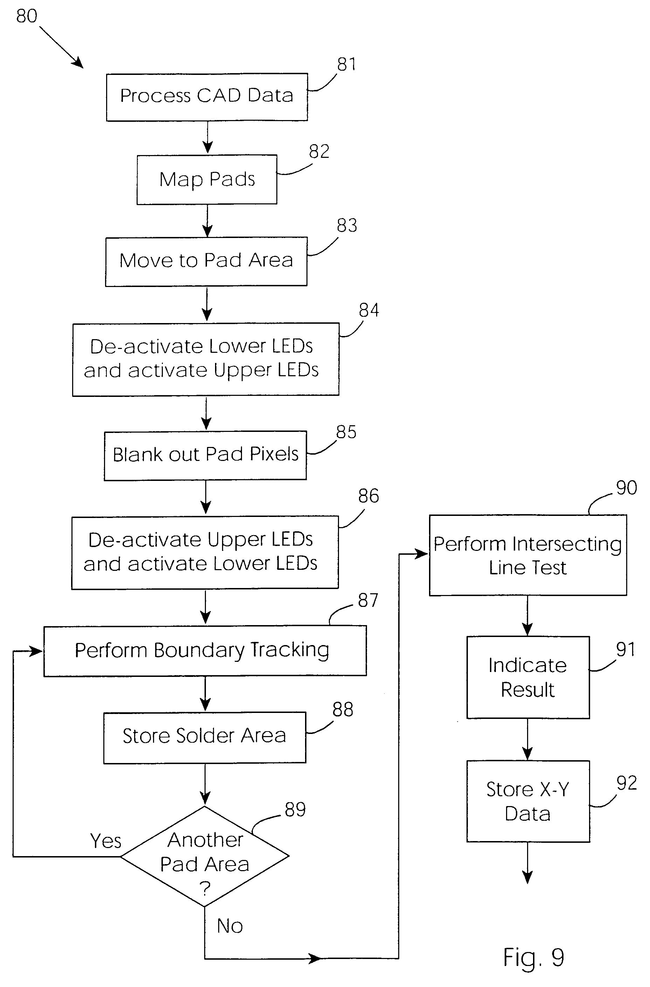

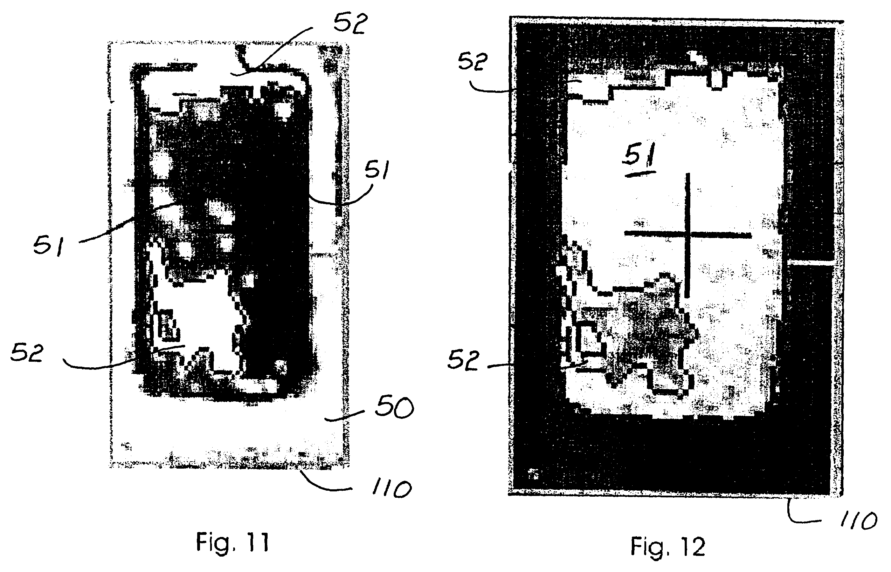

In more detail, and referring to Figs. 9 to 12, the two-dimensional processing is indicated by the method 80 and the three-dimensional processing by the method 100. In a step 81 the image processor 6 receives computer automated design (CAD) data which indicates sub-regions of the target at which pads should be located. These sub-regions are illustrated by the lines 110 in Figs. 11 and 12. The sub-regions are correlated with the current field of view according to fiducials of the target.

Each sub-region has an area of 60 x 100 pixels in which each pixel represents 25 µm x 25 µm. Each pixel is analysed in turn according to its intensity, which a level between 0 and 255. In Fig. 9, the step of mapping the pad sub-region is indicated by the numeral 82 and in step 83 the gantry head is moved so that the current sub-region is directly on the axis of the camera 41.

When at this position, the controller de-activates the lower LEDs 43 and activates the upper LEDs 42. This causes the illumination shown in Fig. 4 in which on-axis beams 53 impinge on the solder blobs 51 on the pads 52. Because the bare parts of the pads 52 are flat, there is a very high proportion of reflected light in the on-axis light 54 detected by the camera 41. A typical image is shown in Fig. 11, in which the bare parts of the pads 52 are relatively bright. It will also be noted that the substrate appears to be quite bright. However, this pattern is not sufficient to draw an accurate boundary around the solder because the substrate is not as reflective as the pads and the accuracy is not sufficient.

In step 85, the image processor blanks out the pixels representing the pad by changing the pixel values to a level below the threshold for paste. For example, in the range of 0 to 255, the threshold for paste may be 150, in which case the value for each of the pad pixels is changed to a value such as 140.

While the gantry head is at the same position, in step 86 the upper LEDs 42 are de-activated and the lower LEDs 43 are activated so that the off-axis beams 55 impinge on the target. Because of the irregular shape of the solder blob surfaces, there is higher reflectivity in the vertical direction for the solder blobs and therefore the substrate can be eliminated because the pixel values will generally be below this threshold level. As shown in Fig. 12, the image processor 6 can define a boundary for the solder paste by thresholding in this manner. Because the off-axis beams 55 highlight the solder very effectively, the boundary of the solder can be more accurately drawn after the second inspection. This image processing is indicated by step 87. The image processor performs boundary tracking in which a line of pixels at the solder boundary is drawn. All pixels within this boundary are then counted according to a boundary-tracking algorithm in which values are assigned to transitions in the X and Y directions. This is an effective way of identifying the solder paste area within the sub-region. These boundaries are illustrated in Fig. 12.

In step 88, the image processor stores the solder areas as a set of boundaries and in step 89 decides to repeat for the next sub-region if one exists (according to the CAD data), or performs solder short tests if all of the regions have been inspected. These tests involve a step 90 in which the processor attempts to map a line of pixels between adjacent solder paste boundaries without contacting either of the adjacent boundaries. If there is any contact, a negative result is outputted in 91, no contact indicating that there is sufficient distance between the solder blobs. Of course, depending on the scale of the pixels, the line may be wider than 1 pixel. In step 92 the image processor 6 stores the X-Y data indicating the solder paste regions.

The system 1 may perform additional sub-pixel processing if the application requires. This is achieved by determining the value of the brightest pixel in the solder paste area and also determining a value for the substrate after the second inspection. This may, for example, provide a scale in the region of 50 to 200. By comparing boundary pixel values with this scale, the image processor 6 determines the proportion of the pixel which represents solder. This is a simple way of achieving sub-pixel accuracy.
The system 1 may periodically test accuracy of the two-dimensional processing by stepping the gantry head in 4µm steps and comparing results. The results should indicate a gradual shift in the direction of head movement.

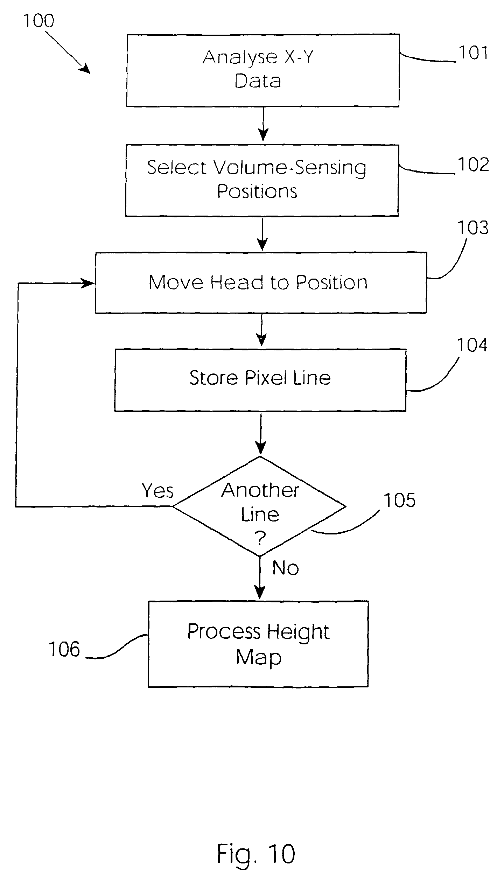

Referring now to Fig. 10, the manner in which height of the solder blobs is determined is now described. In the method 100. in step 101 the image processor 6 analyses the X-Y mapping data and identifies the X-Y position of blobs to be analysed. In most applications only a small proportion of the blobs will be analysed for height and volume. These positions are selected in step 102 and in step 103 the head is moved to the selected positions, at which the laser beam 60 impinges on the selected solder blob. In step 104, the sensor 45 detects the line of laser light. A line 116 is shown in Fig. 7. An important aspect of the arrangement of the laser device 44 is that it is at an angle of 20° to the vertical and more generally should be in the range of 15 to 25° to the vertical. The angle to the vertical causes an offset as viewed in plan when the line 116 traverses an object such as a solder blob on a pad. However, the angle is not large enough to cause significant overhang or shadow on the target. Another important aspect is that the beam 60 impinges on the substrate 50 at an angle of 45° to the X and Y directions. This allows uniform analysis because the pads and the blobs generally extend in either the X or Y directions. This is very important to achieve consistency - the line being distorted to the same extent by objects extending in both directions. Another important aspect of the height inspection is that the camera is vertically above the blob. This allows the received signals to be independent of height of the substrate - some height variations arising in practice.

The pixel line is stored in step 104 and in step 105 the image processor 6 determines if another line needs to be captured and if so steps 103 and 104 are repeated. When all lines have been captured, in step 106 the image processor analyses the height map 70 shown in Fig. 8. The height map 70 is a series of rows of pixels 71, each row representing a single captured line 116. The value of each pixel in the height map 70 is proportional to the distance of the associated part of the target from a datum line D shown in Fig. 8. This datum is a line extending at 45° to the X axis, and therefore the light at the greatest distance from the datum is impinging on the highest part of the solder blob. The height map 70 is therefore a very simple and effective way of representing the 3-dimensional pattern of the target.

In Fig. 8, the arrow X represents the direction of travel of the gantry head between successive image capture positions. The arrow Y represents the direction of correlation between pixels representing the same solder blob. This is because the Y direction is the direction in which the blobs extend. These directions are logical in that when blobs extend in the opposite direction such as those for the different side of an integrated circuit chip, the image processor switches the X and Y directions as shown in Fig. 8 accordingly.

Another important aspect of the three-dimensional image processing is that the received light signals are subjected to median filtering in which pixel outliers are assigned a median value. A new three-dimensional image is constructed from the original image by replacing each pixel value with a new value which is found as the median of that pixel value and all neighbouring values in the original three-dimensional image.

The invention achieves solder paste inspection in a very simple manner. There is only one camera for two-dimensional inspection and one sensor for three-dimensional inspection Height is determined with simple processing of one or a small number of lines of reflected light. The manner in which the two-dimensional inspection is performed provides very accurate solder location data to allow precise three-dimensional inspection.

The invention is not limited to the embodiments to the embodiments described, but may be varied in construction and detail within the scope of the claims.

## Claims

1. A solder bump measurement system (1) comprising means of supporting a target substrate (50) with solder bumps (51), a light source (44) mounted to direct a beam of light at the target, a camera (45) mounted to receive reflected light, and an image processor (6) connected to the camera and comprising means for digitising received light signals and analysing the resultant digital signals to determine solder bump height data, characterised in that,
the light source (44) emits a sheet (60) of light which impinges on the target as a line (116), and
the camera (45) and the light source (44) are mounted at an angle with respect to each other whereby differences in height at which the beam impinges on the target are represented as a pattern (116) in the line as viewed by the camera.

2. A solder bump measurement system as claimed in claim 1, wherein the camera (45) and the light source are mounted so that the camera is vertically above the location at which the light beam impinges on the target.

3. A solder bump measurement system as claimed in claims 1 or 2, wherein the camera and the light source are co-planar and are at a mutual angle in the range of 15° to 25°.

4. A solder bump measurement system as claimed in claim 3, wherein the angle is approximately 20°.

5. A solder bump measurement system as claimed in any preceding claim, wherein the sheet of light impinges on the substrate at an angle of approximately 45° to both orthogonal directions of orientation of the solder blobs.

6. A solder bump measurement system as claimed in any preceding claim, wherein the image processor comprises means for representing each line of light as a row of pixels (71), the intensity of each pixel being proportional to the extent of deviation of the corresponding light.

7. A solder bump measurement system as claimed in any preceding claim, wherein the system comprises a gantry (4), and the camera and the light source are mounted on a gantry head, and the gantry further comprises a drive means (30, 33) for moving the head to selected target regions and to step drive the head to a series of successive discrete positions within the target region.

8. A solder bump measurement systems as claimed in any preceding claim, wherein the image processor (6) comprises means for filtering received digital light signals using median filtering techniques to eliminate pixel outliners.

9. A solder bump measurement systems as claimed in any preceding claim, wherein the system initially performs (101) a two-dimensional inspection of the target to determine the location of solder bumps to be measured.

10. A solder bump measurement systems as claimed in claim 9, wherein the system comprises a vertically-mounted camera, a light source for emitting on-axis beams and a light source for emitting off-axis beams, and the image processor comprises:-
means for switching the light sources, and
means in the image processor for processing light signals reflected from the on-axis beams to eliminate bare pads, and for processing reflected light from off-axis beams to eliminate a substrate.

11. A solder bump measurement systems as claimed in claims 9 or 10, wherein the light sources (42, 43) are light emitting diodes and are arranged in rings symmetrically around the camera.
